Europäisches Patentamt

European Patent Office

Office européen des brevets

(19)

(11) Publication number: **0 033 805**
**B1**

# EUROPEAN PATENT SPECIFICATION

(45) Date of publication of patent specification: **27.06.84**

(51) Int. Cl.³: **H 01 J 37/12**

(21) Application number: **80304589.7**

(22) Date of filing: **18.12.80**

(54) An electrostatic lens assembly for a charged particle beam tube and a method of operating the same.

(30) Priority: **30.01.80 US 116895**

(43) Date of publication of application:
**19.08.81 Bulletin 81/33**

(45) Publication of the grant of the patent:
**27.06.84 Bulletin 84/26**

(84) Designated Contracting States:
**DE FR GB**

(56) References cited:
**GB - A - 1 264 575**
**GB - A - 1 305 523**
**US - A - 2 505 261**
**US - A - 2 884 559**
**US - A - 4 142 132**

(73) Proprietor: **CONTROL DATA CORPORATION**
**8100-34th Avenue South**
**Minneapolis Minnesota 55440 (US)**

(72) Inventor: **Bono, David Currier**
**585 Franklin Street Apt. 4**
**Melrose Massachusetts 02176 (US)**
Inventor: **Fishbein, Marvin**
**88 Tappan Street**
**Brookline Massachusetts 02146 (US)**
Inventor: **Harte, Kenneth Jeremy**
**64 Estabrook Road**
**Carlisle Massachusetts 01741 (US)**

(74) Representative: **Caro, William Egerton et al,**
**J. MILLER & CO. Lincoln House 296-302 High**
**Holborn**
**London WC1V 7JH (GB)**

Courier Press, Leamington Spa, England.

## Description

This invention relates to an electrostatic lens assembly for a charged particle beam tube comprising axially aligned electrostatic lens elements each lens element having an array of micro lenslet apertures formed therein and with each set of axially aligned micro lenslet apertures forming a micro lenslet; a power supply connected to apply an excitation potential to one of the lens elements, and a generator connected to apply a dynamic focus correction potential derived from deflection potentials applied to the charged particle beam tube to a lens element, and to a method of operating the same.

Charged particle beam tubes and in particular electron beam tubes are useable in electron beam accessible memories (EBAMs) for computers and/or electron beam accessible lithography continuously evacuated demountable columns (EBALs) employed in the fabrication of, for example, large scale integrated micro circuits.

United States Patent Specification No. 4 142 132, describes a method and means for dynamic correction and minimisation of aberrations of an electron beam of an electron beam tube employing an electrostatic deflection system. In this U.S. patent specification a preferred construction of a compound, fly's eye type electron beam tube employing an eight-fold coarse deflector, an objective lens of the fly's eye type employing a number of micro lenslets and a micro deflector, is described together with the method and means for providing correction electric potentials to the eightfold coarse deflector for minimising aberrations of the electron beam spot at a target plane. In addition, there is described a method and means for deriving a dynamically corrected focus potential from fine X and Y deflection voltages and applying the dynamically corrected focus potential to the objective lens of the electron beam tube. The disclosure of United States Patent Specification No. 4 142 132 is incorporated into the disclosure of this application in its entirety.

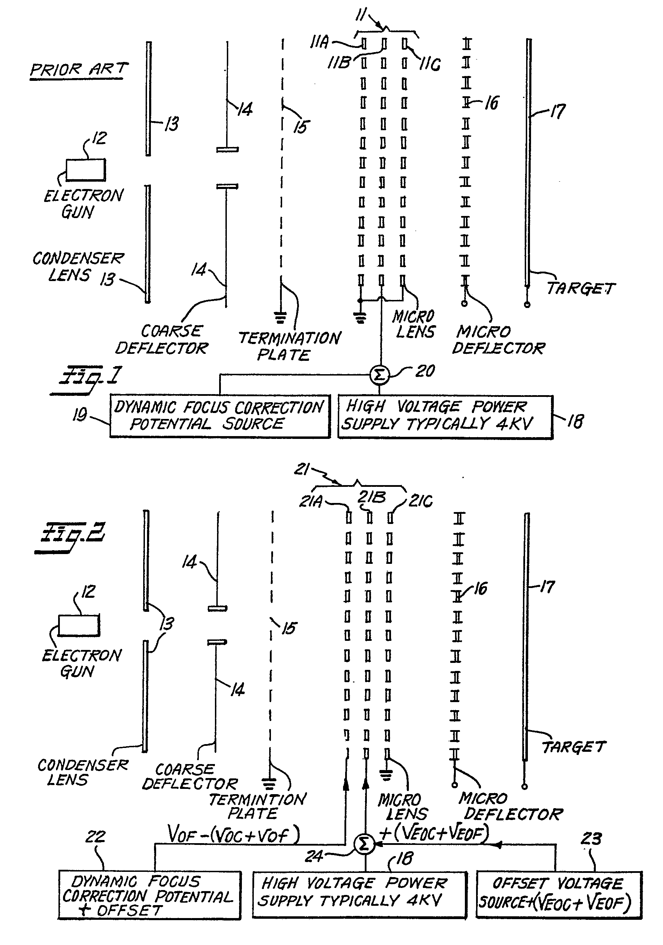

The electron beam tube described in United States Patent Specification No. 4 142 132 employs a classical Einzel lens as the objective lens, as will be discussed more fully hereinafter in connection with Figure 1 hereof. To achieve focus of an electron beam using a classical Einzel lens it is necessary to apply a high energizing potential (typically 4 kilovolts) to a centre element of the standard three element Einzel lens shown in Figure 1. However, in order to maintain focus of a deflected electron beam on a stationary target plane, it is further necessary to apply a dynamic correction potential to the focus voltage so that the focal plane of the lens will fall as closely as possible onto the target plane. For applications requiring rapid changes in order to supply such dynamic correction as illustrated in Figure 1, it is very difficult and expensive to implement circuitry which will rapidly change and very precisely regulate a high voltage power supply. With the arrangement shown in Figure 1, it is necessary that a high voltage power supply provides a high voltage energizing potential of typically four kilovolts (4 kV) and it is necessary to superimpose upon this high energizing potential a dynamic fine focus correction potential of say ±30 to 100 volts and to provide the dynamically corrected focus potential through an amplifier having a typical band width of 1 megahertz. The provision of such circuitry is at best difficult to both build and maintain in operation as well as expensive.

According to one aspect of the present invention there is provided an electrostatic lens assembly for a charged particle beam tube of the type detailed above characterised in that the generator is connected to a lens element different to that to which the excitation potential is applied.

There may be three lens elements, the power supply being connected to apply the excitation potential to an inner lens element, and the generator being connected to apply the dynamic focus correction potential to at least one outer lens element.

In one embodiment, the generator is connected to apply the dynamic focus correction potential to one outer lens element that is designed to be closest to a charged particle beam source of the charged particle beam tube, and the other outer lens element that is designed to be furthest from gve charged particle beam source is maintained at a ground reference potential.

In another embodiment, the outer lens element that is designed to be closest to a charged particle beam source of the charged particle beam tube is connected to a ground reference potential, and the generator is connected to apply the dynamic focus correction potential to the lens element that is designed to be furthest from the charged particle beam source.

In a further embodiment, the power supply is connected to apply the excitation potential to the inner lens element and the generator is connected to apply the dynamic focus correction potential to the two outer lens elements.

There may be four lens elements, two outermost lens elements being connected to a ground reference potential, the generator being connected to apply the dynamic focus correction potential to an inner lens element that is designed to be closest to a charged particle beam source of the charged particle beam tube, and the power supply being connected to apply the excitation potential to the other inner lens element.

The lens assembly may include a potential source connected to add a fixed offset potential to the excitation potential, and a further potential source connected to add a compensating offset potential to the dynamic focusing correction potential in order to distribute and minimize the effect of deflection sweep and astigmatism errors that otherwise might be introduced by the uncompensated dynamic focus correction potential alone.

According to another aspect of the present invention there is provided a charged particle beam tube having an electrostatic lens assembly as recited above.

The charged particle beam tube may include a coarse deflection assembly and a fine deflection assembly, the dynamic focus correction potential $V_{DF}$ being derived from both coarse and fine deflection potentials in accordance with the expression $V_{DF}=V_{CDF}-V_{FDF}$, where $V_{CDF}$ the coarse deflection component of the dynamic focus correction potential is given by the expression $V_{CDF}=M_c(v_x^2+v_y^2)$ with $v_x$ and $v_y$ being the coarse X and Y deflection potentials respectively, and $M_c$ a multiplication factor for the coarse deflection component determined by the coarse deflection assembly, and $V_{FDF}$ the fine deflection component is given by the expression

$$V_{FDF}=M_{fX}v_{FX}^2+M^f_Y v_{FY}^2$$

with $v_{FX}$ and $v_{FY}$ being the fine X and Y deflection potentials and $M_{fX}$ and $M_{fY}$ and X and Y multiplication factors for the fine deflection component determined by the fine deflection assembly.

According to a further aspect of the present invention there is provided a method of operating an electrostatic lens assembly for a charged particle beam tube comprising axially aligned electrostatic lens elements, each lens element having an array of micro lenslet apertures formed therein, and with each set of axially aligned micro lenslet apertures forming a micro lenslet, the method including the application for an excitation potential to one of the lens elements and the application of a dynamic focus correction potential derived from deflection potentials applied to the charged particle beam tube to a lens element being characterised in that the lens element to which the dynamic focus correction potential is applied is different to that to which the excitation potential is applied.

The method may include adding a fixed offset potential to the excitation potential and adding a compensating offset potential to the dynamic focus correction potential in order to distribute and minimize the effect of deflection sweep and astigmatism errors that otherwise might be introduced by the uncompensated dynamic focus correction potential alone.

The invention is illustrated, merely by way of example, in the accompanying drawings, in which:—

Figure 1 is a partial schematic diagram illustrating a conventional EBAM or EBAL tube or demountable column of the compound, fly's eye type employing both coarse and fine deflection assemblies;

Figure 2 is a partial schematic diagram illustrating a charged particle beam tube with one embodiment of an electrostatic lens assembly according to the present invention;

Figure 3 illustrates a modification of the lens assembly of Figure 2;

Figure 4 illustrates another modification of the lens assembly of Figure 2;

Figure 5 illustrates a yet further modification of the lens assembly of Figure 2;

Figure 6 is a simplified functional block diagram of a programmable high voltage power supply suitable for use with a electrostatic lens assembly according to the present invention; and

Figure 7 is a functional block diagram of a dynamic focus correction potential generator circuit for use with an electrostatic lens assembly according to the present invention.

Throughout the drawings like parts have been designated by the same reference numerals.

In order to focus a charged particle beam such as an electron beam using a classical, electrostatic three element Einzel lens assembly 11 shown in Figure 1, it is necessary to supply a high energization potential, typically about 4 kilovolts, to a centre or inner lens element 11B. The lens assembly 11 is composed of two outer lens elements 11A and 11C and the lens element 11B to which the high energising potential is connected. The two outer lens elements 11A, 11C normally are connected together and maintained at a ground reference potential. Figure 1 shows a typical objective micro lens assembly employed in a compound, fly's eye electron beam tube having both a coarse deflection assembly 14 and a fine deflection assembly 16 on opposite sides of the lens assembly 11. Each lens element 11A, 11B, 11C has an array of micro lenslet apertures formed therein and with the micro lenslet apertures in each element being axially aligned with the apertures in the other lens elements so that each set of axially aligned micro lenslet apertures form a micro lenslet of the Einzel type. The electron beam tube further includes an electron gun 12, a condenser lens assembly 13, and a termination plate 15 all located upstream of the lens assembly 11 relative to the electron beam originating at the electron gun 12. The fine deflection assembly 16 and a target element 17 are located downstream of the lens 11.

For a more detailed description of the physical construction and operation of the arrangement shown in Figure 1 reference is made to the above mentioned United States Patent Specification No. 4 142 132, United States Patent Specification No. 4342949, and to United States Patent Specification No. 4200794. Briefly, however, it should be noted that the electron beam produced by electron gun 12 is first focused by the condenser lens assembly 13 and imaged upon the coarse deflection assembly 14. Preferably, the coarse deflection assembly 14 comprises an eight-fold coarse deflector of the type described in United States Patent Specification No. 4 142 132 and has coarse deflection potentials together with appropriate correction potentials supplied thereto for deflecting the electron beam to a desired one of the plurality of micro lenslets formed by the axially aligned lens elements 11A, 11B, 11C of the lens assembly 11. The micro lenslets extend both vertically and horizontally in an X—Y plane so as to present a planar array of micro lenslets with only one of the micro lenslets being accessed by coarse deflection of the electron beam at a given instant. The selected micro lenslet then serves further finely to focus the electron beam and image it upon a succeeding micro deflector element of the fine deflection assembly 16. The fine deflection assembly 16 serves to deflect the finely focused electron beam again in an X—Y plane to cause it to impinge upon a selected point on the target element 17. For definition purposes, it is assumed that the Y-axis accessed through the coarse and fine deflection assemblies 14, 16 extends up and down the target element 17 illustrated in Figure 1, and the X-axis extends into and out of the plane of paper as viewed. It will be appreciated therefore that while the electron beam is deflected by coarse deflection assembly 14 to any of the micro lenslets of the lens assembly 11 other than the centre micro lenslet, that such off-centre micro lenslet lacks coaxial symmetry about the centre axis of the overall objective lens assembly. The termination plate 15 between the coarse deflection assembly 14 and the lens assembly 11 serves to terminate any deflecting field produced by either the coarse deflection assembly 14 or the lens assembly 11 at this point along the axial length of the tube and thereby prevents interaction of such fields during operation of the electron beam tube. It will be appreciated that an additional termination plate similar to the termination plate 15 could be provided between the lens assembly 11 and the fine deflection assembly 16. In most instances, however, the lens assembly 11 and the fine deflection assembly 16 are such that they do not require such an additional termination plate between them to prevent undesired interaction of their respective fields on the operation of one or the other. This same characteristic can also be true of certain electron beam tube designs which do not require a termination plate between the coarse deflection assembly 14 and the lens assembly 11.

In order to achieve focus using the lens assembly 11 shown in Figure 1, it is necessary to apply a high energizing potential typically 5 kilovolts to the lens element 11B. To maintain focus on the stationary target element 17 while the electron beam is deflected as described briefly above, it is further necessary to provide dynamic correction to the focus potential which is derived from the deflection potentials so that the focal plane of the deflected electron beam will fall as closely as possible onto a selected position on the target element. For this purpose, a high voltage power supply 18 is provided along with a dynamic focus correction potential source 19 with the dynamic focus correction potential being added to or otherwise modulated onto the high energising potential through a summing amplifier 20. The problem with this conventional arrangement is that it is extremely difficult and expensive to implement circuitry for dynamically changing (correcting) the very precise, regulated supply potential for application to the lens element 11B.

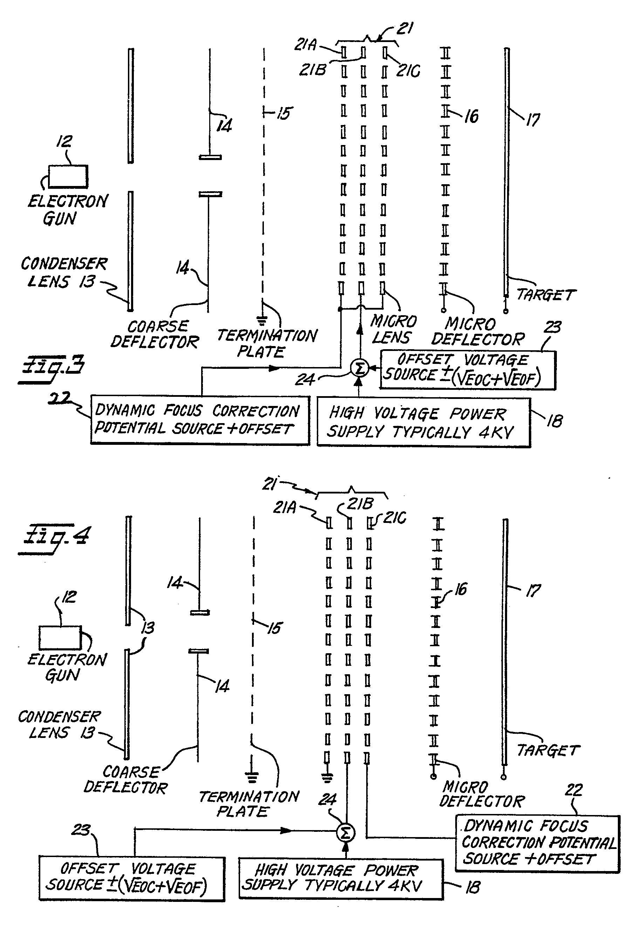

This problem is circumvented in the following embodiments of the present invention by applying the dynamic correction component of the focus voltage to a different element, preferably a lens element 21A of a lens assembly 21 consisting of aligned electrostatic lens elements 21A, 21B, 21C while applying a 4 kV excitation potential to the lens element 21B as shown in Figure 2. Similar to Figure 1, the lens elements 21A—21C each have an array of micro lenslet apertures formed therein with each set of axially aligned micro lenslet apertures in the three lens elements forming a micro lenslet that is axially aligned with a corresponding fine deflector opening the fine deflection assembly 16. The lens element 21C, which is closest to the target element 17 is maintained at ground reference potential. The important distinction is that a high excitation potential $V_E$ from the high voltage power supply 18 is applied to the lens element 21B while the dynamic focus correction potential is separately applied to the lens element 21A closest to the electron gun 12. The lens element 21C is maintained at ground reference potential in order to terminate the electric field of the lens assembly 21. This arrangement is much more advantageous and preferred over the conventional arrangement of Figure 1 since it is relatively simple to design a low voltage (less than 250 volts) amplifier with a 1 megahertz band width for supplying the dynamic focus correction potential to the lens element 21A, than it is to design a high voltage (4 kilovolts or greater) amplifier with a 1 megahertz band width as required for the conventional arrangement of Figure 1.

While the system shown in Figure 2 is preferred because of its greater simplicity and lower cost, it has been determined that at reasonable deflections of the electron beam the application of the dynamic focus correction potential to the lens element 21A of the lens assembly 21, can introduce small aberrations and miscollimations to the electron beam. In addition, higher order position dependence of the defocus of the electron beam is not accounted for by the correction introduced by the dynamic focus correction potential alone. It has been determined further that it is possible to distribute these errors and reduce them to acceptable levels at all locations on the X—Y plane of the target element by offsetting the correction. This is achieved by introducing an offset potential $\pm(V_{EOC}+V_{EOF})$ into the excitation potential $V_E$ so that a combined excitation and offset potential $V_E\pm(V_{EOC}+V_{EOF})$ is applied to the lens element 21B of the lens assembly 21. The offset potential $\pm(V_{EOC}+V_{EOF})$ is supplied from an offset voltage source 23 and can be added to the excitation potential by a summing amplifier 24 shown in detail in Figure 6. Since the offset voltage is essentially a constant term, no difficulty is experienced in either adding or subtracting this term to the excitation potential $V_E$ in order to derive the combined excitation and offset potential $V_E\pm(V_{EOC}+V_{EOF})$ that is applied to the lens element 21B. The offset potential $\pm(V_{EOC}+V_{EOF})$ is balanced by a constant term $\pm(v_{oc}+v_{of})$ that is added to the dynamic focus correction potential $V_{DF}$ supplied to the lens element 21A. The constant term $\pm(v_{oc}+v_{of})$ is separately developed and is proportional to but not the same as the offset potential $\pm(V_{EOC}+V_{EOF})$.

The dynamic focus correction potential $V_{DF}$ supplied to the lens element 21A is given by the expression $V_{DF}=V_{CDF}+V_{FDF}$ where $V_{CDF}$ is the coarse deflection component of the dynamic focus correction potential $V_{DF}$ and has the following functional form:

$$V_{CDF}=M_c(v_{cx}^2+v_{cy}^2)-v_{oc} \qquad (1)$$

In equation (1) $v_{cx}$ and $v_{cy}$ are the coarse deflection potentials supplied to the coarse deflection assembly, $M_c$ is a multiplication factor determined by the parameters of the coarse deflection assembly and $v_{oc}$ is the offset voltage component for the coarse deflection dynamic focus component.

$V_{FDF}$ is the fine deflection component of the dynamic focus correction potential $V_{DF}$ and has the following functional form:

$$V_{FDF}=M_{fx}v_{fx}^2+M_{fy}v_{fy}^2-v_{of} \qquad (2)$$

where $v_{fx}$ and $v_{fy}$ are the fine deflection potentials that are applied to the X and Y fine deflection assembly, $M_{fx}$ and $M_{fy}$ are the X and Y multiplication factors for the fine deflection assembly as determined by the design parameters of the fine deflection assembly and $v_{of}$ is the offset voltage component for the fine deflection component of the fine dynamic focus correction potential.

Figure 3 shows a modification of the electrostatic lens assembly of Figure 2 wherein the excitation potential $V_E$ and the offset potential $\pm(V_{EOC}+V_{OEF})$ from offset voltage source 23 is supplied through the summing amplifier 24 to the lens element 21B of the lens assembly 21. However, in the electrostatic lens assembly of Figure 3, the dynamic focus correction potential together with its two offset components $V_{DF}\pm(v_{oc}+v_{of})$ is supplied from the offset voltage source 23 to both of the lens elements 21A, 21C. In this electrostatic lens assembly, termination of the objective micro lens field on the inlet side of the lens assembly 21 is provided by the termination plate 15 and termination of the objective micro lens field on the outlet side of the lens assembly is provided by the fine deflection assembly 16 whose design is such that interaction of the objective micro lens fields with the fine deflecting electrostatic fields of the fine deflection assembly is avoided.

Figure 4 of the drawings illustrates a further embodiment of an electrostatic lens assembly according to the present invention where again the excitation potential and offset component $V_E\pm(V_{EOC}+V_{EOF})$ again is supplied to the lens element 21A of the lens assembly 21. In Figure 4, however, the dynamic focus correction potential and offset components $V_{DF}\pm(v_{oc}+v_{of})$ are applied to the lens element 21C closest to the target element 17 and the lens element 21A closest to the electron gun 12 is maintained at reference ground potential. In this arrangement, similar to that of Figure 3, the termination plate 15 terminates the objective micro lens field on the entrance side of the lens assembly, and the fine deflection assembly 16 terminates the micro lens field on the exit side of the lens assembly.

Figure 5 illustrates still another alternative embodiment of an electrostatic lens assembly according to the present invention wherein the lens assembly 21 is composed by four lens element 21A—21D. The high excitation potential and offset potential $V_E\pm(V_{EOC}+V_{EOF})$, is supplied to the lens elements 21C which is closest to the target element 17. The dynamic focus correction potential plus its offset component $V_{DF}\pm(v_{oc}+v_{of})$ is supplied to the lens element 21B which is closest to the electron gun 12 and hence constitutes the entrance inner lens element of the lens assembly while the lens element 21C constitutes the exit inner lens element. The remaining two lens elements 21A, 21D are tied together electrically and maintained at reference ground potential. With this arrangement, axial symmetry of the electrostatic field of the lens assembly 21 is assured. The termination plate 15 also is employed primarily to assure termination of the electrostatic field of the coarse deflection assembly 14 in the axial direction of the lens assembly 21.

In operation, the electrostatic lens assemblies of Figures 3, 4, 5 function in essentially the same manner as was described with reference to the electrostatic lens assembly in Figure 2, and provide the same constructional advantages in that it is not necessary to modulate or otherwise combine a dynamic focus correction potential with the excitation potential supplied to the lens assembly 21. The electrostatic lens assembly of Figure 2 is preferred, due to the fact that it can be practiced without requiring additional lens elements, and yet provides all of the advantages obtained by separately supplying the high excitation potential to one lens element and the dynamic focus correction potential to a separate lens element while at the same time obtaining an essentially symmetrically axial objective micro lens field by reason of the presence of the termination plate 15 and the grounded lens element 21C.

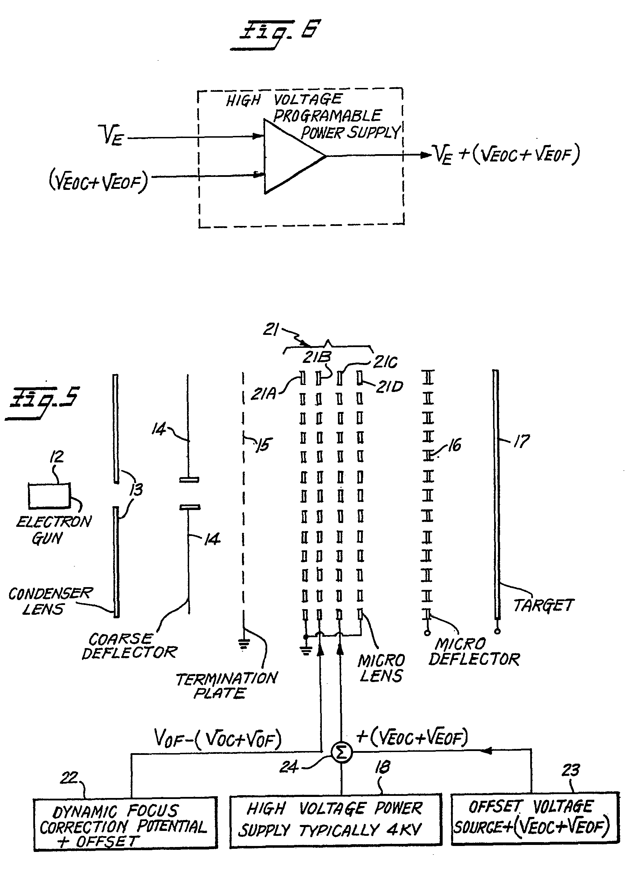

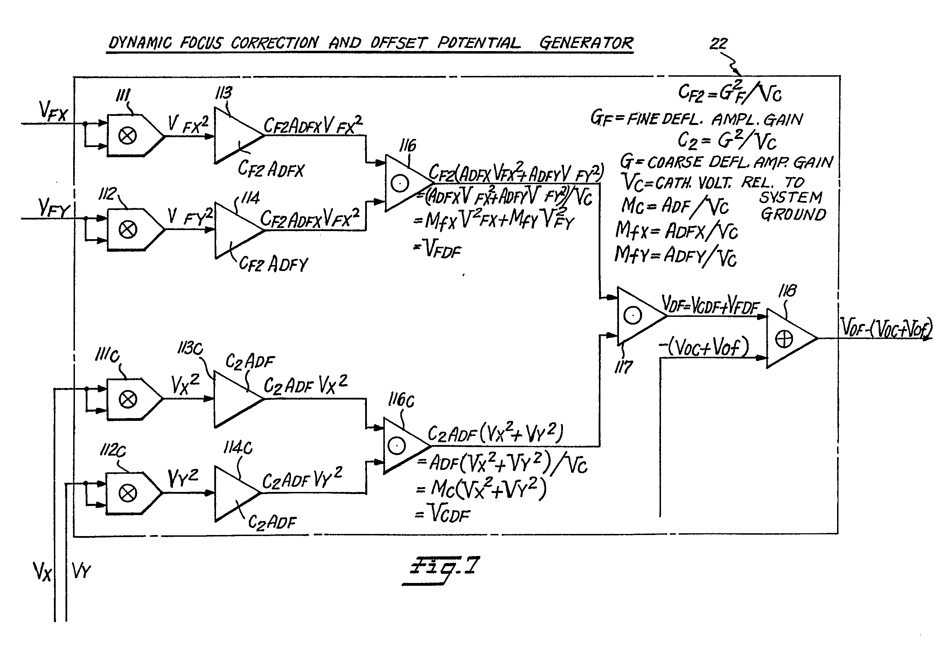

Figure 7 of the drawings is a functional block diagram of a dynamic focus correction potential generator suitable for use in deriving the dynamic focus correction potential from both the fine deflection potentials and the coarse deflection potentials supplied to the beam tube and to provide the necessary offset potentials as discussed above. The dynamic focus correction potential generator 22 is composed of a pair of input multiplier amplifiers 111, 112 of conventional, commercially available, integrated circuit construction. A low level fine deflection voltage $v_{FX}$ is supplied to the input of the multiplier 11 for multiplication by itself to derive at the output of the multiplier 111 a signal $v_{FX}^2$. Similarly, a low level fine deflection voltage $v_{FY}$ is supplied to the input of a multiplier 112 for multiplication by itself to derive at the output of multiplier 112 a signal $v_{FY}^2$. An operational amplifier 113 of conventional, commercial construction is provided having a transfer function $C_{F2}A_{DFX}$ and is connected to the output of multiplier 111 for deriving at its output a signal $C_{F2}A_{DFX}v_{FX}^2$ where the value $C_{F2}$ is a scaling factor having the value $G_F^2/V_c$ with $G_F$ being the fine deflection amplifier gain and the potential $-V_c$ being equal to the cathode voltage relative to system ground reference potential. The term $A_{DFX}$ is a constant determined by the design parameters of the fine X deflection assembly as explained more fully in United States Patent Specification No. 4 142 132. It should be further noted that the term $A_{DFX}/V_c=M_{mf}$ is the X multiplication factor in equation (2) set forth above. The multiplier 112 has its output supplied through an operational amplifier 114 that is similar in construction to the amplifier 113 but has the transfer function $C_{F2}A_{DFY}$ and derives at its output a signal $C_{F2} \cdot A_{DFY}v_{FY}^2$. The constant $A_{DFY}$ is a constant determined by the parameters of the fine Y deflection assembly and $C_{F2} \cdot A_{DFY}/V_c=M_{fy}$ the Y multiplication factor in equation (2). The outputs of the multipliers 113, 114 are supplied to a summing amplifier 116 of conventional, commercially available construction which derives at its output a dynamic fine correction potential

$$V_{FDF}=C_{F2}(A_{DFX} \cdot v_{FX}^2+A_{DFY} \cdot v_{FY}^2$$

$$=A_{DFX} \cdot v_{FX}^2+A_{DFY} \cdot v_{FY}^2)/V_c$$

$$=M_{fx}V_{FX}^2+M_{fy}V_{FY}$$

where $V_{FX}=G_F \cdot v_{FX}$ and $V_{FY}=G_F \cdot v_{FY}$ are the X and Y fine deflection potentials, respectively, and where $V_{FDF}$ is the dynamic focus correction potential component derived from the fine deflection potentials.

The coarse deflection potentials $v_X$ and $v_Y$ are supplied to respective multiplier amplifiers 111C, 112C, and through operational amplifiers 113C and 114C, respectively to a second summing amplifier 116C. The multipliers 111C, 112C, operational amplifiers 113C, 114C and the summing amplifier 116C all are similar in construction and operation to the correspondingly numbered elements described in relation to the fine deflection channel, but which instead operate on the coarse deflection potentials $v_X$ and $v_Y$. At the output of the summing amplifier 116C, a coarse dynamically corrected focus potential $V_{CDF}$ is derived which is equal to

$$C_2A_{DF}(v_X^2+v_Y^2)=A_{DF}(V_X^2+V_Y^2)/V_c$$

$$=M_c(V_X^2+V_Y^2)=V_{CDF}$$

where $C_2$ is a scaling factor having a value $G^2/V_c$ with G being equal to the coarse deflection amplifier gain, $A_{DF}$ is a constant determined by the coarse deflection amplifier parameters, $M_c$ is the multiplication factor for the coarse deflection assembly employed in equation (1) above and is equal to $A_{DF}/V_c$ and $V_X=G \cdot v_X$ and $V_Y=G \cdot v_Y$ are the coarse X and Y deflection potentials, respectively. The constant $A_{DF}/V_c=M_c$ as well as the multiplication factors $M_{fx}$ and $M_{fy}$ can be determined either empirically or by computer simulation.

The fine dynamic focus correction component $V_{FDF}$ derived at the output of the summing amplifier 16 and the coarse dynamic focus correction component $V_{CDF}$ derived at the output of the summing amplifier 116C, are supplied as inputs to a third summing amplifier 117 which derives at its output the dynamic focus correction potential $V_{DF}=V_{CDF}+V_{FDF}$. This dynamic focus correction potential is then supplied to a fourth summing amplifier 118 along with a compensating offset potential $-(v_{oc}+v_{of})$ to derive at the output of the summing amplifier 118 the combined dynamic focus potential plus compensating offset potential given by $V_{DF}-(v_{oc}+v_{of})$ that then is supplied to the lens element 21B as shown in Figure 2. The compensating offset voltage source supplying the compensating offset potential $-(v_{oc}+v_{of})$ suitably may comprise a potentiometer and the offset voltage source 23 employed to develop the offset voltage $+(v_{oc}+v_{of})$ likewise may comprise a potentiometer having its output added to the output from the high voltage power supply 18.

From the foregoing description it will be appreciated that the above described electrostatic lenses provide a relatively simple, low cost and reliable method and means for applying the dynamic component of a focus potential to an objective lens assembly used in EBAM and/or EBAL tubes and demountable columns of the compound fly's eye type having both coarse and fine deflection assemblies. This achieves simplification in construction and reduction in cost while at the same time reducing to a minimum electron beam aberrations and beam astigmatism at the target element. As noted above, the electrostatic lens assemblies are particularly suitable for use with evacuated electron beam tubes or demountable continuously evacuated electron beam columns of the two-stage, compound fly's eye type wherein a two-stage eight-fold electrostatic coarse deflection assembly is employed in conjunction with a fly's eye, objective micro lens assembly and fine deflection assembly in a single evacuated tube or a continuously evacuated column structure. It should be noted, however, that the invention is not restricted in its application to use with electron beam tubes but may used with other charged particle beam tubes or columns which employ electrostatic lens assemblies requiring dynamic focus correction.

## Claims

1. An electrostatic lens assembly for a charged particle beam tube comprising: axially aligned electrostatic lens elements (21A—21C; 21A—21D) each lens element having an array of micro lenslet apertures formed therein and with each set of axially aligned micro lenslet apertures forming a micro lenslet; a power supply (18) connected to apply an excitation potential to one of the lens elements (21B; 21C); and a generator (22) connected to apply a dynamic focus correction potential derived from deflection potentials applied to the charged particle beam tube to a lens element (21A, 21C, 21B), characterised in that the generator (22) is connected to a lens element (21A, 21C, 21B) different to that to which the excitation potential is applied.

2. An electrostatic lens assembly as claimed in claim 1 characterised in that there are three lens elements (21A—21C), the power supply being connected to apply the excitation potential to the inner lens element (21B), and the generator (22) being connected to apply the dynamic focus correction potential to at least one outer lens element (21A, 21C).

3. An electrostatic lens assembly as claimed in claim 2 characterised in that the generator (22) is connected to apply the dynamic focus correction potential to the outer lens element that is closest to the charged particle beam source of the charged particle beam tube (Figure 2), and the other outer lens element that is furthest from the charged particle beam source is maintained at a ground reference potential.

4. An electrostatic lens assembly as claimed in claim 2 characterised in that the outer lens element that is closest to the charged particle beam source of the charged particle beam tube is connected to a ground reference potential, and the generator (22) is connected to apply the dynamic focus correction potential to the lens element that is furthest from the charged particle beam source (Figure 4).

5. An electrostatic lens assembly as claimed in claim 2 characterised in that the power supply is connected to apply the excitation potential to the inner lens element and the generator (22) is connected to apply the dynamic focus correction potential to the two outer lens elements (Figure 3).

6. An electrostatic lens assembly as claimed in claim 1 characterised in that there are four lens elements (21A—21D), the two outermost lens elements (21A, 21D) being connected to a ground reference potential, the generator (22) being connected to apply the dynamic focus correction potential to an inner lens element (21B) that is closest to the charged particle beam source of the charged particle beam tube, and the power supply being connected to apply the excitation potential to the other inner lens element (21C).

7. An electrostatic lens assembly as claimed in any of claims 2 to 6 characterised by including a potential source (23) connected to add a fixed offset potential to the excitation potential, and a further potential source connected to add a compensating offset potential to the dynamic focusing correction potential in order to distribute and minimize the effect of deflection sweep and astigmatism errors that otherwise might be introduced by the uncompensated dynamic focus correction potential alone.

8. A charged particle beam tube having an electrostatic lens assembly as claimed in any preceding claim.

9. A charged particle beam tube as claimed in claim 8 including a coarse deflection assembly (14) and a fine deflection assembly (16), the dynamic focus correction potential $V_{DF}$ being derived from both coarse and fine deflection potentials in accordance with the expression $V_{DF}=V_{CDF}-V_{FDF}$, where $V_{CDF}$ the coarse deflection component of the dynamic focus correction potential is given by the expression $V_{CDF}=M_c(v_x^2+v_y^2)$ with $v_x$ and $v_y$ being the coarse X and Y deflection potentials respectively, and $M_c$ a multiplication factor for the coarse deflection component determined by the coarse deflection assembly, and $V_{FDF}$ the fine deflection component is given by the expression

$$V_{FDF}=M_{fx}v_{fx}+M^f_y v_{FY}^2$$

with $v_{FX}$ and $v_{FY}$ being the fine X and Y deflection potentials and $M_{fx}$ and $M_{fy}$ the X and Y multiplication factors for the fine deflection component determined by the fine deflection assembly.

10. A method of operating an electrostatic lens assembly for a charged particle beam tube comprising axially aligned electrostatic lens elements (21A—21C; 21A—21D), each lens element having an array of micro lenslet apertures formed therein, and with each set of axially aligned micro lenslet apertures forming a micro lenslet, the method including the application of an excitation potential to one of the lens elements (21B; 21C) and the application of a dynamic focus correction potential derived from the deflection potentials applied to the charged particle beam tube to a lens element (21A; 21C; 21B) being characterised in that the lens element (21A; 21C; 21B) to which the dynamic focus correction potential is applied is different to that to which the excitation potential is applied.

11. A method as claimed in claim 10 characterised by adding a fixed offset potential to the excitation potential and adding a compensating offset potential to the dynamic focus correction potential in order to distribute and minimize the effect of deflection sweep and astigmatism errors that otherwise might be introduced by the uncompensated dynamic focus correction potential alone.

**Patentansprüche**

1. Elektrostatische Linsenanordnung für eine Röhre mit Ladungsteilchenstrahl, mit in Axialrichtung ausgerichteten elektrostatischen Linsenelementen (21A bis 21C; 21A bis 21D), in denen jeweils eine Anordnung von kleinen Teillinsenöffnungen ausgebildet ist, wobei jeder Satz von axial ausgerichteten kleinen Teillinsenöffnungen eine kleine Teillinse bildet, mit einer zur Zuführung eines Ansteuerpotentials an eines der Linsenelemente (21B, 21C) angeschalteten Leistungsversorgung (18) und mit einem Generator (22), der zur Zuführung eines dynamischen Fokussierkorrekturpotentials, das von der Ladungsteilchenstrahlröhre zugeführten Ablenkpotentialen abgeleitet ist, an ein Linsenelement (21A, 21C, 21B) angeschaltet ist, dadurch gekennzeichnet, daß der Generator (22) an ein Linsenelement (21A, 21C, 21B) angeschaltet ist, das von demjenigen verschieden ist, dem das Ansteuerpotential zugeführt wird.

2. Elektrostatische Linsenanordnung nach Anspruch 1, dadurch gekennzeichnet, daß drei Linsenelemente (21A bis 21C) vorgesehen sind, daß die Leistungsversorgung zur Zuführung des Ansteuerpotentials an das innere Linsenelement (21B) angeschaltet ist und daß der Generator (22) zur Zuführung des dynamischen Fokussierkorrekturpotentials an zumindest ein äußeres Linsenelement (21A, 21C) angeschaltet ist.

3. Elektrostatische Linsenanordnung nach Anspruch 2, dadurch gekennzeichnet, daß der Generator (22) zur Zuführung des dynamischen Fokussierkorrekturpotentials an dasjenige äußere Linsenelement angeschaltet ist, das der Ladungsteilchenstrahlquelle der Ladungsteilchenstrahlquelle der Ladungsteilchenstrahlröhre am nächsten liegt (Fig. 2), und daß das andere äußere Linsenelement, das von der Ladungsteilchenstrahlquelle am weitesten entfernt ist, auf Erdbezugspotential gehalten ist.

4. Elektrostatische Linsenanordnung nach Anspruch 2, dadurch gekennzeichnet, daß das äußere Linsenelement, das der Ladungsteilchenstrahlquelle der Ladungsteilchenstrahlröhre am nächsten liegt, mit einem Erdbezugspotential verbunden ist und daß der Generator (22) zur Zuführung des dynamischen Fokussierkorrekturpotentials an dasjenige Linsenelement angeschaltet ist, das von der Ladungsteilchenstrahlquelle am weitesten entfernt ist (Fig. 4).

5. Elektrostatische Linsenanordnung nach Anspruch 2, dadurch gekennzeichnet, daß die Leistungsversorgung zur Zuführung des Ansteuerpotentials an das innere Linsenelement angeschaltet ist und daß der Generator (22) zur Zuführung des dynamischen Fokussierkorrekturpotentials an die beiden äußeren Linsenelemente angeschaltet ist (Fig. 3).

6. Elektrostatische Linsenanordnung nach Anspruch 1, dadurch gekennzeichnet, daß vier Linsenelemente (21A bis 21D) vorgesehen sind, daß die beiden äußersten Linsenelemente (21A, 21D) mit einem Erdbezugspotential verbunden sind, daß der Generator (22) zur Zuführung des dynamischen Fokussierkorrekturpotentials an ein inneres Linsenelement (21B) angeschaltet ist, das der Ladungsteilchenstrahlquelle der Ladungsteilchenstrahlröhre am nächsten liegt, und daß die Leistungsversorgung zur Zuführung des Ansteuerpotentials an das andere innere Linsenelement (21C) angeschaltet ist.

7. Elektrostatische Linsenanordnung nach einem der Ansprüche 2 bis 6, gekennzeichnet durch eine Potentialquelle (23), die zur Addition eines festen Offset-Potentials zu dem Ansteuerpotential angeschaltet ist, und eine weitere Potentialquelle, die zur Addition eines Kompensations-Offset-Potentials zu dem dynamischen Fokussierkorrekturpotential angeschaltet ist, um die Auswirkung von Ablenkbewegungs- und Astigmatismus-Fehlern zu verteilen und zu verringern, die andernfalls durch das unkompensierte dynamische Fokussierkorrekturpotential allein eingeführt werden könnten.

8. Ladungsteilchenstrahlröhre, dadurch gekennzeichnet, daß sie eine elektrostatische Linsenanordnung nach einem der vorhergehenden Ansprüche aufweist.

9. Ladungsteilchenstrahlröhre nach Anspruch 8 mit einer Grobablenkanordnung (14) und einer Feinablenkanordnung (16), bei der das dynamische Fokussierkorrekturpotential $V_{DF}$ sowohl von den Grob- als auch den Feinablenkpotentialen entsprechend der Gleichung $V_{DF}=V_{CDF}-V_{FDF}$ abgeleitet wird, worin $V_{CDF}$ die Grobablenkkomponente des dynamischen Fokussierkorrekturpotentials ist und durch die Gleichung $V_{CDF}=M_c(v_X^2+v_Y^2)$ bestimmt ist,

worin $v_X$ und $v_Y$ die X- bzw. Y-Ablenkpotentiale sind, während $M_C$ ein Multiplikationsfaktor für die Grobablenkkomponente ist, der durch die Grobablenkanordnung bestimmt ist, und worin $V_{FDF}$ die Feinablenkkomponente ist, die durch die Gleichung

$$V_{FDF}=M_{fX} \cdot v_{FX}+M_{fY} \cdot v_{FY}{}^2$$

bestimmt ist, worin $v_{FX}$ und $v_{FY}$ die X- und Y-Feinablenkpotentiale und $M_{fX}$ und $M_{fY}$ die X- und Y-Multiplikationsfaktoren für die Feinablenkkomponente sind, die durch die Feinablenkanordnung bestimmt sind.

10. Verfahren zum Betrieb einer elektrostatischen Linsenanordnung für eine Ladungsteilchenstrahlröhre mit axial ausgerichteten elektrostatischen Linsenelementen (21A bis 21C; 21A bis 21D), in denen jeweils eine Anordnung von kleinen Teillinsenöffnungen ausgebildet ist, wobei jeder Satz von axial ausgerichteten kleinen Teillinsenöffnungen eine kleine Teillinse bildet, und wobei das Verfahren die Zuführung eines Ansteuerpotentials an eines der Linsenelemente (21B; 21C) und die Zuführung eines dynamischen Fokussierkorrekturpotentials, das von den an die Ladungsteilchenstrahlröhre angelegten Ablenkpotentialen abgeleitet ist, an ein Linsenelement (21A; 21C; 21B) einschließt, dadurch gekennzeichnet, daß das Linsenelement (21A; 21C; 21B), an das das dynamische Fokussierkorrekturpotential angelegt wird, von dem verschieden ist, an das das Ansteuerpotential angelegt ist.

11. Verfahren nach Anspruch 10, gekennzeichnet durch die Addition eines festen Offset-Potentials zu dem Ansteuerpotential und die Addition eines Kompensations-Offset-Potentials zu dem dynamischen Fokussierkorrekturpotential zur Verteilung und weitgehenden Verringerung der Wirkung von Ablenkbewegungs- und Astigmatismus-Fehlern, die andernfalls durch das unkompensierte dynamische Fokussierkorrekturpotential allein eingeführt werden könnten.

**Revendications**

1. Une structure de lentille électrostatique pour un tube à faisceau de particules chargées comprenant: des éléments de lentille électrostatique alignés axialement (21—21C; 21A—21D), avec un réseau d'ouvertures de micro-lentilles formé dans chaque élément de lentille, et avec chaque ensemble d'ouvertures de micro-lentilles alignées axialement formant une micro-lentille; une alimentation (18) connectée de façon à appliquer un potentiel d'excitation à l'un des éléments de lentille (21B; 21C); et un générateur (22) connecté de façon à appliquer à un élément de lentille (21A, 21C, 21B) un potentiel de correction de focalisation dynamique qui est élaboré à partir de potentiels de déflexion appliqués au tube à faisceau de particules chargées, caractérisée en ce que le générateur (22) est connecté à un élément de lentille (21A, 21C, 21B) différent de celui auquel le potentiel d'excitation est appliqué.

2. Une structure de lentille électrostatique selon la revendication 1, caractérisée en ce qu'elle comporte trois éléments de lentille (21A—21C), l'alimentation est connectée de façon à appliquer le potentiel d'excitation à l'élément de lentille intérieur (21B) et le générateur (22) est connecté de façon à appliquer le potentiel de correction de focalisation dynamique à au moins un élément de lentille extérieur (21A, 21C).

3. Une structure de lentille électrostatique selon la revendication 2, caractérisée en ce que le générateur (22) est connecté de façon à appliquer le potentiel de correction de focalisation dynamique à l'élément de lentille extérieur qui est le plus proche de la source de faisceau de particules chargées du tube à faisceau de particules chargées (figure 2), et l'autre élément de lentille extérieur, qui est le plus éloigné de la source de faisceau de particules chargées, est maintenu à un potentiel de référence de masse.

4. Une structure de lentille électrostatique selon la revendication 2, caractérisée en ce que l'élément de lentille extérieur qui est le plus proche de la source de faisceau de particules chargées du tube à faisceau de particules chargées est connecté à un potentiel de référence de masse, et le générateur (22) est connecté de façon à appliquer le potentiel de correction de focalisation dynamique à l'élément de lentille que est le plus éloigné de la source de faisceau de particules chargées (figure 4).

5. Une structure de lentille électrostatique selon la revendication 2, caractérisée en ce que l'alimentation est connectée de façon à appliquer le potentiel d'excitation à l'élément de lentille intérieur et le générateur (22) est connecté de façon à appliquer le potentiel de correction de focalisation dynamique aux deux éléments de lentille extérieurs (figure 3).

6. Une structure de lentille électrostatique selon la revendication 1, caractérisée en ce qu'elle comporte quatre éléments de lentille (21A—21D), les deux éléments de lentille extérieurs (21A—21D) sont connectés à un potentiel de référence de masse, la générateur (22) est connecté de façon à appliquer le potentiel de correction de focalisation dynamique à un élément de lentille intérieur (21B) qui est le plus proche de la source de faisceau de particules chargées du tube à faisceau de particules chargées, et l'alimentation est connectée de façon à appliquer le potentiel d'excitation à l'autre élément de lentille intérieur (21C).

7. Une structure de lentille électrostatique selon l'une quelconque des revendications 2 à 6, caractérisée en ce qu'elle comprend une source de potentiel (23) connectée de façon à ajouter un potentiel de décalage fixe au poten-

17     **0 033 805**     18

tiel d'excitation, et une source de potentiel supplémentaire connectée de façon à ajouter un potentiel de décalage de compensation au potentiel de correction de focalisation dynamique, afin de répartir et de minimiser l'effet d'erreurs d'astigmatisme et du balayage de déflexion qui pourraient par ailleurs être introduites par le seul potentiel de correction de focalisation dynamique non compensé.

8. Un tube à faisceau de particules chargées comportant une structure de lentille électrostatique selon l'une quelconque des revendications précédentes.

9. Un tube à faisceau de particules chargées selon la revendication 8, comprenant une structure de déflexion grossière (14) et une structure de déflexion fine (16), le potentiel de correction de focalisation dynamique $V_{DF}$ étant élaboré à partir des potentiels de déflexion grossière et fine conformément à l'expression $V_{DF}=V_{CDF}-V_{FDF}$, dans laquelle $V_{CDF}$, c'est-à-dire la composante de déflexion grossière du potentiel de correction de focalisation dynamique, est donnée par l'expression $V_{CDF}=M_C(v_X^2+v_Y^2)$, en désignant respectivement par $v_X$ et $v_Y$ les potentiels de déflexion grossière X et Y, et par $M_C$ un facteur multiplicatif pour la composante de déflexion grossière, déterminé par la structure de déflexion grossière, et dans laquelle $V_{FDF}$, c'est-à-dire la composante de déflexion fine, est donnée par l'expression

$$V_{FDF}=M_{fX}v_{FX}+M_{fY}v_{FY}^2,$$

en désignant par $v_{FX}$ et $v_{FY}$ les potentiels de déflexion fine X et Y, et par $M_{fX}$ et $M_{fY}$ les facteurs multiplicatifs X et Y pour la composante de déflexion fine, qui sont déterminés par la structure de déflexion fine.

10. Un procédé d'utilisation d'une structure de lentille électrostatique pour un tube à faisceau de particules chargées comprenant des éléments de lentille électrostatique alignés axialement (21A—21C; 21A—21D), avec un réseau d'ouvertures de micro-lentilles formé dans chaque élément de lentille, et avec chaque ensemble d'ouvertures de micro-lentilles alignées axialement formant une micro-lentille, le procédé comprenant l'application d'un potentiel d'excitation à l'un des éléments de lentille (21B; 21C) et l'application à un élément de lentille (21A; 21C; 21B) d'un potentiel de correction de focalisation dynamique élaboré à partir des potentiels de déflexion appliqués au tube à faisceau de particules chargées, caractérisé en ce que l'élément de lentille (21A; 21C; 21B) auquel le potentiel de correction de focalisation dynamique est appliqué est différent de celui auquel le potentiel d'excitation est appliqué.

11. Un procédé selon la revendication 10, caractérisé en ce qu'on ajoute un potentiel de décalage fixe au potentiel d'excitation et on ajoute un potentiel de décalage de compensation au potentiel de correction de focalisation dynamique, dans le but de répartir et de minimiser l'effet d'erreurs d'astigmatisme et de balayage de déflexion qui pourraient par ailleurs être introduites par le seul potentiel de correction de focalisation dynamique non compensé.

**0 033 805**

Fig.1

PRIOR ART

ELECTRON GUN
12

CONDENSER LENS 13
13

COARSE DEFLECTOR
14

TERMINATION PLATE
15

MICRO LENS
11A 11B 11C
16

MICRO DEFLECTOR

TARGET
17

Σ 20

DYNAMIC FOCUS CORRECTION POTENTIAL SOURCE
19

HIGH VOLTAGE POWER SUPPLY TYPICALLY 4KV
18

Fig.2

ELECTRON GUN
12

CONDENSER LENS

COARSE DEFLECTOR
13 14

TERMINTION PLATE
15

MICRO LENS
21A 21B 21C
16

MICRO DEFLECTOR

TARGET
17

$V_{of} - (V_{oc} + V_{of})$

$+ (V_{eoc} + V_{eof})$

Σ 24 18

DYNAMIC FOCUS CORRECTION POTENTIAL + OFFSET
22

HIGH VOLTAGE POWER SUPPLY TYPICALLY 4KV

OFFSET VOLTAGE SOURCE $+ (V_{eoc} + V_{eof})$
23

1

_fig.3_

_fig.4_

*Fig. 6*

$$V_E \longrightarrow$$

HIGH VOLTAGE
PROGRAMABLE
POWER SUPPLY

$$(V_{EOC} + V_{EOF}) \longrightarrow$$

$$\longrightarrow V_E + (V_{EOC} + V_{EOF})$$

*Fig.5*

ELECTRON
GUN

CONDENSER
LENS

COARSE
DEFLECTOR

TERMINATION
PLATE

MICRO
LENS

MICRO
DEFLECTOR

TARGET

$$V_{OF} - (V_{OC} + V_{OF})$$

$$+ (V_{EOC} + V_{EOF})$$

DYNAMIC FOCUS
CORRECTION POTENTIAL
+ OFFSET

HIGH VOLTAGE POWER
SUPPLY TYPICALLY 4KV

OFFSET VOLTAGE
SOURCE $+ (V_{EOC} + V_{EOF})$

22

$C_{F2} = G_F^2 / V_C$

$G_F = $ FINE DEFL. AMPL. GAIN

$C_2 = G^2 / V_C$

$G = $ COARSE DEFL. AMP. GAIN

$V_C = $ CATH. VOLT. REL. TO SYSTEM GROUND

$M_C = A_{DF} / V_C$

$M_{fX} = A_{DFX} / V_C$

$M_{fY} = A_{DFY} / V_C$

$V_{FX}$

111

$V_{FX}^2$

113

$C_{F2} A_{DFX} V_{FX}^2$

$C_{F2} A_{DFX}$

$V_{FY}$

112

$V_{FY}^2$

114

$C_{F2} A_{DFX} V_{FX}^2$

$C_{F2} A_{DFY}$

116

$C_{F2}(A_{DFX} V_{FX}^2 + A_{DFY} V_{FY}^2)$

$= (A_{DFX} V_{FX}^2 + A_{DFY} V_{FY}^2)/V_C$

$= M_{fX} V_{FX}^2 + M_{fY} V_{FY}^2$

$= V_{FDF}$

117

$V_{DF} = V_{CDF} + V_{FDF}$

118

$-(V_{OC} + V_{of})$

$V_{OF} - (V_{OC} + V_{of})$

111C

$V_X^2$

113C

$C_2 A_{DF}$

$C_2 A_{DF} V_X^2$

$C_2 A_{DF}$

112C

$V_Y^2$

114C

$C_2 A_{DF} V_Y^2$

$C_2 A_{DF}$

116C

$C_2 A_{DF}(V_X^2 + V_Y^2)$

$= A_{DF}(V_X^2 + V_Y^2)/V_C$

$= M_C(V_X^2 + V_Y^2)$

$= V_{CDF}$

$V_X$   $V_Y$

*Fig.1*

0033 805